# EUROPÄISCHE PATENTANMELDUNG

(11) **EP 2 760 131 A1**
(43) Veröffentlichungstag der Anmeldung: **30.07.2014**
(21) Anmeldenummer: 14000304.7
(22) Anmeldetag: 28.01.2014
(51) Int. Cl.: H03H 7/38, H03F 1/56

(54) **Anpassungsnetzwerk**

(30) Priorität: 28.01.2013 DE 102013001353
(71) Anmelder: Krohne AG, 4019 Basel (CH)
(72) Erfinder: Huijzer, Arie, 3363 BS Sliedrecht (NL)
(74) Vertreter: Gesthuysen Patent- und Rechtsanwälte

(57) **Zusammenfassung**

Beschrieben und dargestellt ist ein Anpassungsnetzwerk zur Anpassung der Impedanz einer Last (1) an die Impedanz einer elektrischen Energiequelle (2), mit einer Induktivität (3) und einer Kapazität (4).

Anpassungsnetzwerke der in Rede stehenden Art werden auch in Verbindung mit Ultraschallwandlern verwendet. Dabei leisten die bekannten Anpassungsnetzwerke dann das Gewollte, wenn der Ultraschallwandler Ultraschallwellen sendet ("Transmit Situation"), jedoch das Gewollte dann nicht leisten, wenn der Ultraschallwandler Ultraschallwellen empfangen soll ("Receive Situation"). Dieser Problematik ist erfindungsgemäß dadurch entsprochen, dass parallel zum Ausgang des Anpassungsnetzwerks eine Reihenschaltung (5) aus einer nicht-linearen Impedanz und der Induktivität (3) oder der Kapazität 4 geschaltet ist.

## Beschreibung

Die Erfindung betrifft ein Anpassungsnetzwerk zur Anpassung der Impedanz einer Last an die Impedanz einer elektrischen Spannungsquelle oder Stromquelle bzw. einer elektrischen Energiequelle, mit einer Induktivität und einer Kapazität.

Häufig spricht man entweder von einer elektrischen Spannungsquelle oder von einer elektrischen Stromquelle. In aller Regel ist jedoch eine elektrische Energiequelle gemeint, weil in aller Regel eine elektrische Spannungsquelle auch einen elektrischen Strom zur Verfügung stellen soll und eine elektrische Stromquelle nur Sinn macht, wenn sie auch eine elektrische Spannung zur Verfügung stellt. (Nicht verkannt wird, dass es auch elektrische Spannungsquellen gibt, die keinen elektrischen Strom liefern müssen; um elektrische Spannungsquellen dieser Art geht es jedoch vorliegend nicht.)

Allgemein bekannt ist, dass eine elektrische Energiequelle dann ein Maximum an elektrischer Energie liefern bzw. abgeben kann, wenn die Impedanz einer angeschlossenen Last der Impedanz der elektrischen Energiequelle entspricht.

Da im Allgemeinen die Impedanz einer an eine elektrische Spannungsquelle angeschlossenen Last nicht identisch ist mit der Impedanz dieser elektrischen Energiequelle, verwendet man Anpassungsnetzwerke, die dafür sorgen, dass die elektrische Energiequelle als Last eine Impedanz "sieht", die der Impedanz der elektrischen Energiequelle entspricht. Mit der Formulierung, dass die elektrische Energiequelle als Last eine Impedanz "sieht", die der Impedanz der elektrischen Energiequelle entspricht, ist folgendes gemeint;

Genau genommen kann ein Anpassungsnetzwerk der hier in Rede stehenden Art natürlich nicht die Impedanz der Last verändern, also auch nicht die Impedanz der Last an die Impedanz einer elektrischen Spannungsquelle anpassen. Vielmehr ist bei der angesprochenen Verwendung eines Anpassungsnetzwerks das Anpassungsnetzwerk einerseits an die elektrische Energiequelle und andererseits an die Last angeschlossen. Mit der Formulierung, dass die elektrische Energiequelle als Last eine Impedanz "sieht", ist also gemeint, dass das Anpassungsnetzwerk für die elektrische Energiequelle eine Impedanz darstellt, die der Impedanz der elektrischen Energiequelle entspricht.

Häufig weisen Anpassungsnetzwerke der zuvor angesprochenen Art zur Anpassung der Impedanz einer Last an die Impedanz einer elektrischen Energiequelle eine Induktivität und eine Kapazität auf. Von einem solchen Anpassungsnetzwerk soll auch im Folgenden ausgegangen werden, wenn auch andere Anpassungsnetzwerke bekannt sind, auch vorstellbar sind, die das leisten, was zuvor erläutert worden ist.

Im Folgenden sollen Überlegungen in Verbindung mit bei Ultraschallwandlern einzusetzenden Anpassungsnetzwerken dargestellt werden.

Ultraschallwandler als ein wesentlicher Teil eines Ultraschalldurchflussmessgeräts weisen als wesentliches Funktionselement ein Wandlerelement auf, häufig ein Piezoelement, das zum Senden oder zum Empfangen von Ultraschallwellen ausgebildet ist. Soll das Wandlerelement zum Senden von Ultraschallwellen eingesetzt werden, ist eine elektrische Energiequelle notwendig, die das Wandlerelement mit elektrischer Energie versorgt. Wird das Wandlerelement zum Empfangen von Ultraschallwellen eingesetzt, dann ist in aller Regel dem Wandlerelement ein elektrischer Verstärker nachgeschaltet. Der erste Fall wird nachfolgend mit "transmit situation", der zweite Fall mit "receive situation" bezeichnet.

Ein Anpassungsnetzwerk ist ein Vierpol. Bei Verwendung in Verbindung mit einem Ultraschallwandler ist zu unterscheiden zwischen der Situation, dass der Ultraschallwandler Ultraschallwellen senden soll ("transmit situation"), und der Situation, dass der Ultraschallwandler Ultraschallwellen empfangen soll ("receive situation"). Für die "transmit situation" ist das Anpassungsnetzwerk einerseits an die elektrische Energiequelle und andererseits an das Wandlerelement des Ultraschallwandlers anzuschließen. Demgegenüber ist für die "receive situation" das Anpassungsnetzwerk einerseits an das Wandlerelement des Ultraschallwandlers und andererseits an einen Verstärker anzuschließen.

Verwendet man das in Rede stehende, zuvor beschriebene Anpassungsnetzwerk in Verbindung mit einem Ultraschallwandler so stellt man fest, dass das Gewollte in der Situation erreicht wird, in der der Ultraschallwandler Ultraschallwellen sendet ("transmit situation"), jedoch nicht das leistet, was es leisten soll, wenn der Ultraschallwandler Ultraschallwellen empfangen soll ("receive situation").

Der zuvor angesprochenen Problematik wird nun erfindungsgemäß dadurch entsprochen, dass bei dem eingangs beschriebenen Anpassungsnetzwerk parallel zum Ausgang des Anpassungsnetzwerks eine Reihenschaltung aus einer nicht-linearen Impedanz und der Induktivität oder der Kapazität geschaltet ist. Vorzugsweise sind als nicht-lineare Impendanz zwei anti-parallel geschaltete Dioden vorgesehen.

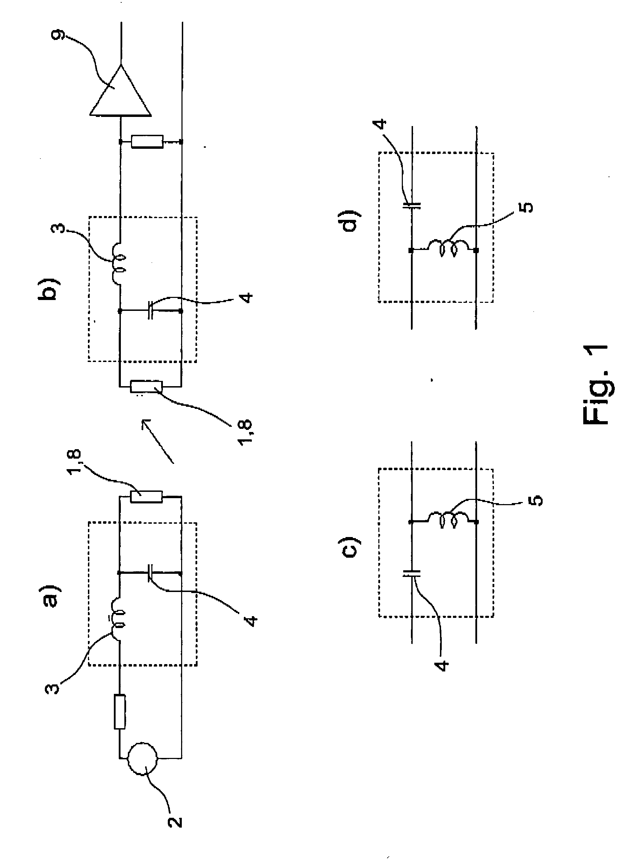

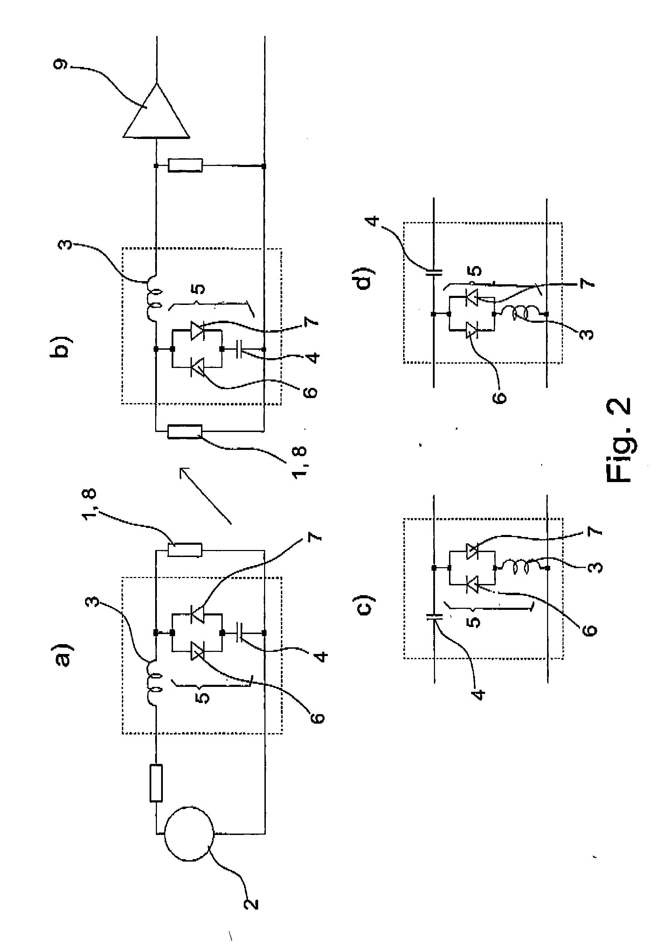

Nachfolgend wird in Verbindung mit zwei Figuren der Stand der Technik einerseits, Fig. 1, und das erfindungsgemäße Anpassungsnetzwerk andererseits, Fig. 2, erläutert.

Die Fig. 1 zeigt Anpassungsnetzwerke zur Anpassung der Impedanz einer Last 1 an die Impedanz einer elektrischen Energiequelle 2. In ihrem grundsätzlichen Aufbau bestehen die dargestellten Anpassungsnetzwerke, und zwar sowohl die in Fig. 1 als auch die in Fig. 2, aus einer Induktivität 3 und einer Kapazität 4. Sowohl in der Fig. 1 als auch in der Fig. 2 zeigen die Skizzen (a) und (c) Anpassungsnetzwerke für die Situation "transmit situation", während die Skizzen (b) und (d), wiederum sowohl in der Fig. 1 als auch in der Fig. 2, Anpassungsnetzwerke für die Situation "receive situation" zeigen.

Erfindungsgemäß ist, wie das Fig. 2 zeigt, parallel zum Ausgang des Anpassungsnetzwerks, Skizzen (a) und (c), "transmit situation", bzw. parallel zum Eingang des Anpassungsnetzwerks, Skizzen (b) und (d), "receive situation", eine Reihenschaltung 5, bestehend aus einer nicht-linearen Impedanz und der Induktivität 3 oder der Kapazität 4 geschaltet. Im Ausführungsbeispiel sind als nicht-lineare Impedanz zwei anti-parallel geschaltete Dioden 6,7 vorgesehen.

Die erfindungsgemäßen, in Fig. 2 dargestellten Anpassungsnetzwerke arbeiten bei der Situation "transmit situation" normal, wenn die Spannung der elektrischen Energiequelle 2 hinreichend groß ist, die anti-parallel geschalteten Dioden 6, 7 also leitend sind. In der Situation "receive situation" arbeitet das dargestellte Anpassungsnetzwerk praktisch nicht, wenn die Eingangsspannung so klein ist, dass die anti-parallel geschalteten Dioden 6, 7 nicht leiten. Eine solche "receive situation" ist gegeben, wenn als Last 1 das Wandlerelement eines Ultraschallwandlers vorgesehen ist.

Im Übrigen zeigen die Skizzen (b) in den Fig. 1 und 2 noch einen für die "receive situation" vorgesehenen Verstärker 9.

## Patentansprüche

1. Anpassungsnetzwerk zur Anpassung der Impedanz einer Last (1) an die Impedanz einer elektrischen Energiequelle (2), mit einer Induktivität (3) und einer Kapazität (4),
**dadurch gekennzeichnet,**
**dass** parallel zum Ausgang des Anpassungsnetzwerks oder parallel zum Eingang des Anpassungsnetzwerks eine Reihenschaltung (5) aus einer nicht-linearen Impedanz und der Induktivität (3) oder der Kapazität (4) geschaltet ist.

2. Anpassungsnetzwerk nach Anspruch 1, **dadurch gekennzeichnet, dass** als nicht-lineare Impedanz zwei anti-parallel geschaltete Dioden (6, 7) vorgesehen sind.
